# EUROPEAN PATENT APPLICATION

(11) **EP 2 991 108 A1**
(43) Date of publication of application: **02.03.2016**
(21) Application number: 13882841.3
(22) Date of filing: 22.04.2013
(51) Int. Cl.: H01L 23/48, H01L 23/28, H01L 23/29, H01L 23/31, H01L 25/07, H01L 25/18

(54) **SEMICONDUCTOR DEVICE AND METHOD OF MANUFACTURE THEREOF**

(71) Applicant: Mitsubishi Electric Corporation, Tokyo 100-8310 (JP)
(72) Inventor: KUNIMITSU Takahiro, Chiyoda-ku, Tokyo 100-8310 (JP); TANAKA Daisuke, Chiyoda-ku, Tokyo 100-8310 (JP)
(74) Representative: Hoffmann Eitle
(86) International application number: PCT/JP2013/061787
(87) International publication number: WO 2014/174573

(57) **Abstract**

A resin electrode capacitor having resin electrodes is used as a chip capacitor (35) mounted so as to bridge between two seating faces (21 and 23) of a lead frame. According to this configuration, when stress due to a step difference between the seating faces (21 and 23) or stress due to a pressure from mold resin (7) during encapsulation is applied to the chip capacitor (35), it is the resin electrodes that peel of f . Hence, breakage of an element base can be prevented, which can in turn forestall a failure of a semiconductor device.

## Description

### Technical Field

The present invention relates to a semiconductor device formed by mounting electronic components on a lead frame followed by encapsulation with resin, and to a manufacturing method of the same.

### Background Art

In a semiconductor device in the related art, a lead frame, which is a wiring member, has a plurality of electrically independent seating faces. Electronic components are mounted so as to bridge between two seating faces and the lead frame and the electronic components are encapsulated with mold resin (PTL 1).

### Citation List

### Patent Literature

PTL 1: JP-A-2006-32774

### Summary of Invention

### Technical Problem

In the semiconductor device configured as above, when stress is applied to an electronic component mounted so as to bridge between two electrically independent seating faces of the lead frame, electrodes peel off or cracking occurs in the electronic component. Such inconveniences cause a failure of the semiconductor device. Stress applied to the electronic component is induced by various factors and includes stress induced by a step difference between two seating faces, stress induced by a pressure from resin during encapsulation with mold resin, stress induced by heat from a heating element mounted on the lead frame, and so on.

The invention was devised to solve the problem discussed above and has an object to obtain a semiconductor device that achieves excellent durability by preventing breakage of an electronic component mounted so as to bridge between two electrically independent seating faces of a lead frame due to stress applied to the electronic component. The invention also has another object to provide a manufacturing method of a semiconductor device capable of easing stress applied to an electronic component mounted so as to bridge between two seating faces.

### Solution to Problem

A semiconductor device of the invention includes a lead frame having a plurality of electrically independent seating faces, electronic components mounted on the seating faces via a conductive bonding material, and mold resin encapsulating the lead frame and the electronic components. The semiconductor device is characterized in that the electronic components include a first electronic component mounted so as to bridge between two seating faces, and that the first electronic component has resin electrodes.

Also, a manufacturing method of a semiconductor device of the invention is characterized by including: a first step of preparing a lead frame having an outer frame, a plurality of electrically independent seating faces disposed on an inner side of the outer frame, and connection portions each extending from the seating faces in a plurality of different directions and integrated with the outer frame; a second step of mounting a first electronic component so as to bridge between two seating faces of the lead frame, the second step being carried out subsequently to the first step; a third step of placing the lead frame on a pedestal, encapsulating the lead frame and the first electronic component with molten mold resin while the two seating faces on which is mounted the first electronic component are pressed by corresponding pressing members in a direction to the pedestal, and removing the pressing members before the mold resin cures, the third step being carried out subsequently to the second step; and a fourth step of cutting the outer frame and the connection portions unwanted for a circuit, the fourth step being carried out subsequently to the third step.

### Advantageous Effects of Invention

The semiconductor device of the invention is configured in such a manner that a first electronic component mounted so as to bridge between two seating faces has resin electrodes. Owing to this configuration, when stress is applied to the first electronic component, it is the resin electrodes that peel off and damage on the component main body can be prevented, which can in turn forestall a failure of the semiconductor device. A semiconductor device with excellent durability can be thus obtained.

The manufacturing method of a semiconductor device of the invention is configured in such a manner that a lead frame is placed on a pedestal after a first electronic component is mounted so as to bridge between two seating faces of the lead frame and the lead frame and the first electronic component are encapsulated with mold resin while the two seating faces on which is mounted the first electronic component are pressed by corresponding pressing members in a direction to the pedestal. This configuration can prevent breakage of the first electronic component due to a pressure from the mold resin, which can in turn forestall a failure of the semiconductor device. A semiconductor device with excellent durability can be thus obtained.

The above and other objects, characteristics, viewpoints, and advantageous effects of the invention will become more apparent from the following detailed description taken in conjunction with the accompanying drawings.

### Brief Description of Drawings

[Fig. 1] Fig. 1 is a circuit diagram of a semiconductor device according to a first embodiment of the invention.
[Fig. 2] Fig. 2 is a top view showing an internal configuration of the semiconductor device according to the first embodiment of the invention.
[Fig. 3] Fig. 3 is a top view showing a lead frame according to the first embodiment of the invention.
[Fig. 4] Fig. 4 is a view showing a configuration of a resin electrode capacitor employed in the semiconductor device according to the first embodiment of the invention.
[Fig. 5] Fig. 5 is a top view used to describe a manufacturing method of a semiconductor device according to the first embodiment of the invention.
[Fig. 6] Fig. 6 is a partial cross section used to describe the manufacturing method of a semiconductor device according to the first embodiment of the invention.
[Fig. 7] Fig. 7 is a top view used to describe the manufacturing method of a semiconductor device according to the first embodiment of the invention.
[Fig. 8] Fig. 8 is a partial cross section of the semiconductor device according to the first embodiment of the invention.

### Description of Embodiment

### First Embodiment

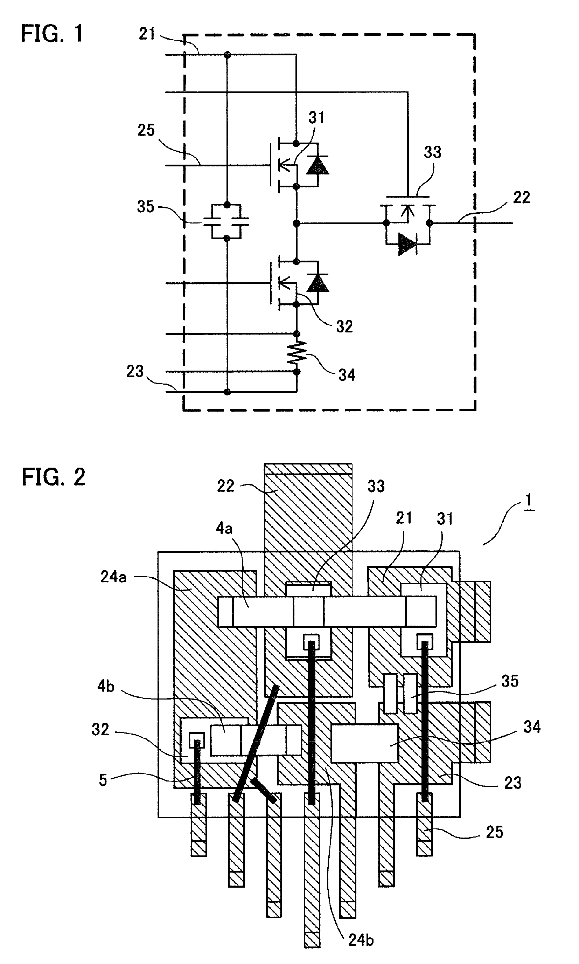

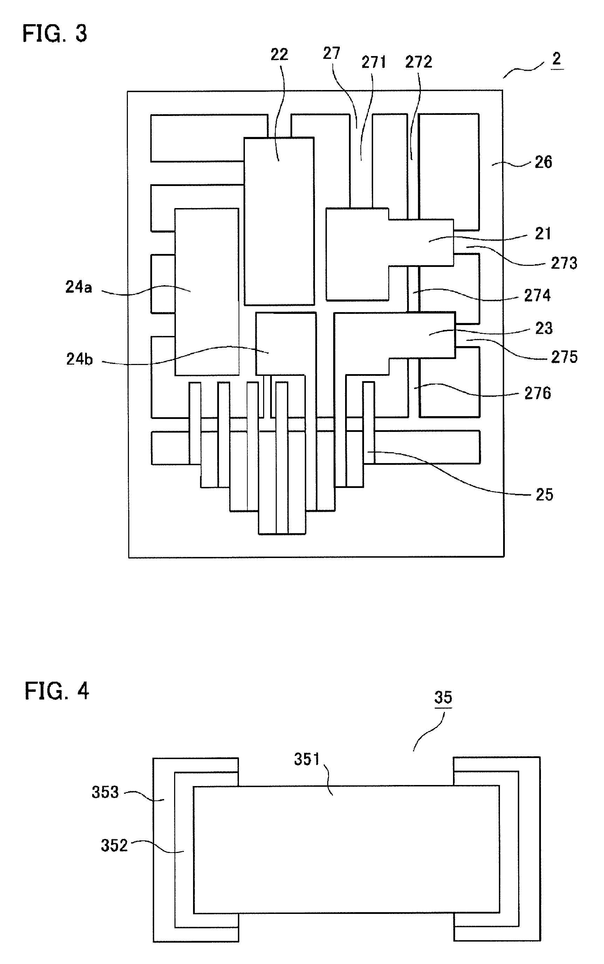

A semiconductor device according to a first embodiment of the invention will be described with reference to the drawings. Fig. 1 is a circuit diagram of the semiconductor device of the first embodiment to show one phase of a three-phase bridge circuit forming a motor drive circuit. Fig. 2 shows an internal configuration of the semiconductor device according to the first embodiment of the invention. Fig. 3 shows a lead frame of the semiconductor device of the first embodiment before electronic components are mounted. Like portions are labeled with like reference numerals in the respective drawings referred to in the following.

As are shown in Fig. 1 and Fig. 2, a semiconductor device 1 includes a power semiconductor chip 31 as a switching element forming an upper arm to output AC from DC, a power semiconductor chip 32 as a switching element forming a lower arm, a relay semiconductor chip 33 as a switching element furnished with a relay function, a shunt resistor 34 to monitor a motor current, and two chip capacitors (first electronic component) 35 as a snubber capacitor that suppresses noises. The power semiconductor chips 31 and 32 forming the upper and lower arms can be, for example, FETs. Also, the chip capacitors 35 can be, for example, ceramic capacitors.

The relay semiconductor chip 33 is interposed between an output terminal of the semiconductor device 1 and an output terminal of the bridge circuit and connects or disconnects an output of the semiconductor device 1. The shunt resistor 34 is interposed between the lower arm and GND and the chip capacitors 35 are interposed between an outside power supply and GND. These electronic components are mounted on seating faces of a copper lead frame having high conductivity and high heat conduction via a conductive bonding material and encapsulated with mold resin.

The lead frame forming the semiconductor device 1 of the first embodiment is press-cut in a condition as shown in Fig. 3. The lead frame 2 shown in Fig. 3 has a plurality of electrically independent seating faces 21, 22, 23, 24a, and 24b and electronic components are mounted on these seating faces. The seating face 21 is provided with a power-supply terminal portion connected to an outside power-supply terminal. The seating face 22 is provided with a power line portion to connect a motor power line. The seating face 23 is provided with a GND portion connected to outside GND. The seating faces 24a and 24b are provided with die pad portions forming an internal wire of the semiconductor device 1.

Further, the lead frame 2 has a signal lead-out portion 25 through which signals are inputted from and outputted to the outside, an outer frame 26 surrounding the outer periphery, and beams 27 or terminals (not shown) serving as connection portions connecting each seating face and the outer frame 26. The beams 27 are an unwanted portion for a circuit. However, the beams 27 are integrated with the outer frame 26 or other beams 27 to support the respective seating faces 21, 22, 23, 24a, and 24b.

In the semiconductor device 1 of the first embodiment, two chip capacitors 35 are mounted so as to bridge between the two seating faces 21 and 23 and the semiconductor device 1 is characterized by using resin electrode capacitors having resin electrodes as the chip capacitors 35. As is shown in Fig. 4, the resin electrode capacitor is formed of an element base 351, which is a capacitor element, internal electrodes 352, and resin electrodes 353 to serve as outside electrodes.

When stress is applied to the resin electrode capacitor from the outside, it is the resin electrodes 353 that peel off. Hence, damage on the internal electrodes 352 and the element base 351 is prevented and breakage of the component main body can be avoided. It should be noted that the resin electrodes 353 do not completely peel off from the capacitor element and therefore an operation of the circuit is maintained.

One electrode of the chip capacitor 35 is bonded to the seating face 21 on which the power semiconductor chip 31 as the switching element is mounted to be connected to an outside power-supply terminal, and the other electrode is bonded to the seating face 23 on which the GND portion is formed. By directly mounting the chip capacitors 35 so as to bridge between the seating faces 21 and 23 and disposing the chip capacitors 35 in the vicinity of the switching element in this manner, switching noises are eliminated effectively.

A manufacturing method of a semiconductor device of the first embodiment will be described. Initially, the lead frame 2 shown in Fig. 3 is prepared as a first step. More specif ically, the lead frame 2 is prepared so as to have the outer frame 26, a plurality of the electrically independent seating faces 21, 22, 23, 24a, and 24b disposed on the inner side of the outer frame 26, and the beams 27 each extending from these seating faces in a plurality of different directions and integrated with the outer frame 26 and or other beams 27.

Of a plurality of the seating faces, three or more beams 27 extend in different directions from each of the two seating faces 21 and 23 on which the chip capacitors 35 are mounted so as to bridge therebetween, and each seating face is integrated with the outer frame 26 or other beams 27. More specifically, beams 271, 272, 273, and 274 extend from the seating face 21. Also, beams 274, 275, and 276 extend from the seating face 23.

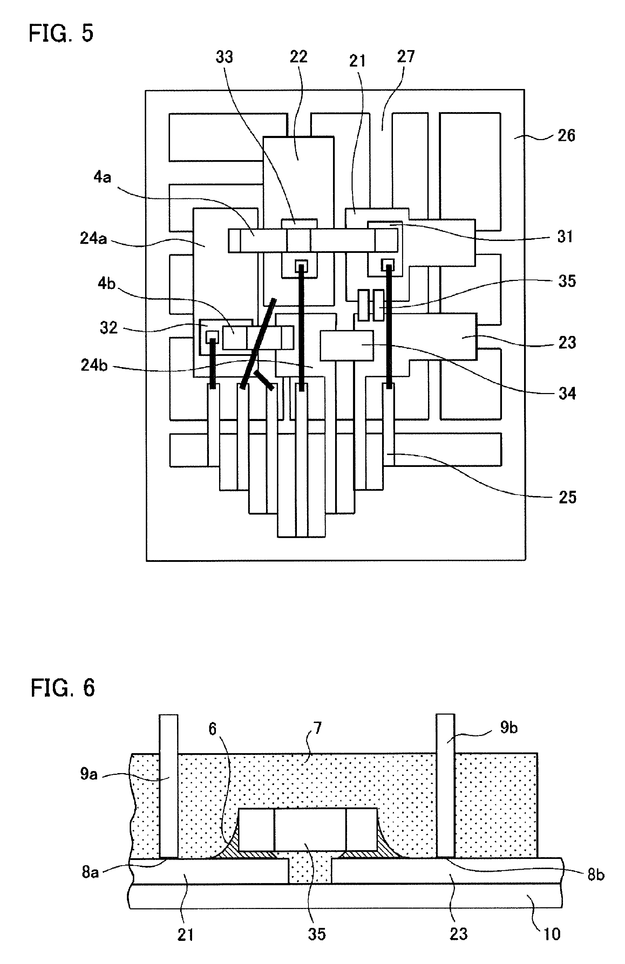

Subsequently, as is shown in Fig. 5, electronic components are mounted on the respective seating faces of the lead frame 2 as a second step. More specifically, the chip capacitors 35 having resin electrodes are mounted so as to bridge between the two seating faces 21 and 23. As has been described, the seating faces 21 and 23 are integrated with the outer frame 26 or other beams 27 by three or more beams 27 each extending in different directions. This configuration can suppress a step difference between the seating face 21 and the seating face 23 when the chip capacitors 35 are mounted. Hence, stress applied to the chip capacitors 35 due to the step difference can be eased.

Also, the power semiconductor chip 31 forming the upper arm is mounted on the seating face 21 and the power semiconductor chip 32 forming the lower arm is mounted on the seating face 24a. Likewise, the relay semiconductor chip 33 is mounted on the seating face 22. Subsequently, the power semiconductor chip 31, the relay semiconductor chip 33, and the seating face 24a serving as the die pad portion are interconnected by a power terminal portion 4a. Also, the power semiconductor chip 32 mounted on the seating face 24a and the seating face 24b serving as the die pad portion on which is mounted the shunt resistor 34 are connected by a power terminal portion 4b. The shunt resistor 34 is mounted so as to bridge between the seating face 24b and the seating face 23 forming the GND portion.

Further, the gate of the power semiconductor chip 31, the gate and the drain of the power semiconductor chip 32, and the gate and the source of the relay semiconductor chip 33 are connected to the signal lead-out portion 25 by wire bonding 5. When these electronic components are mounted, lead-free solder, a eutectic solder material, or a conductive adhesive can be used as the conductive bonding material 6 (see Fig. 6) . It should be noted that these electronic components are not necessarily mounted in a specific order.

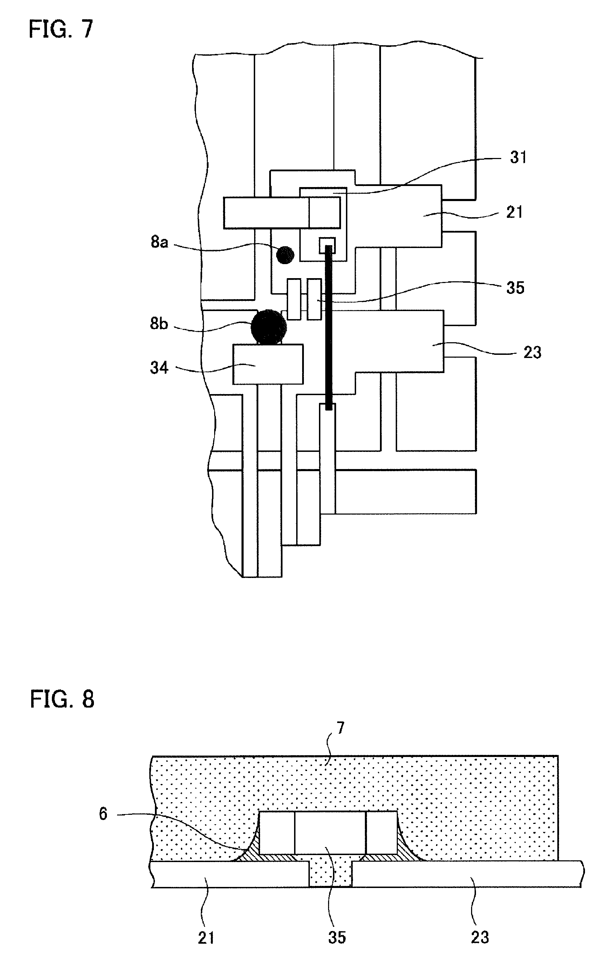

Subsequently, as a third step, as are shown in Fig. 6 and Fig. 7, the lead frame 2 is mounted on a pedestal 10 and press portions 8a and 8b provided, respectively, to the two seating faces 21 and 23 on which the chip capacitors 35 are mounted in the second step are pressed, respectively, by pins 9a and 9b serving as pressing members in a direction to the pedestal 10. In this state, molten mold resin is poured into the die to encapsulate the lead frame 2 on a surface side where the electronic components are mounted as well as the electronic components including the chip capacitors 35 mounted on this surface with the mold resin 7.

When encapsulated with the mold resin 7, the interior of the module becomes thermally homogeneous due to heat conduction of the mold resin 7. Hence, thermal stress applied to the lead frame 2 is eased and so is stress applied to the electronic components. It should be noted that the pins 9a and 9b are removed before the mold resin 7 cures. Hence, as is shown in Fig. 8, the mold resin 7 of the completed semiconductor device 1 has no holes that are otherwise left by removing the pins 9a and 9b.

As has been described, the seating faces 21 and 23 on which are mounted the bridging chip capacitors 35 are integrated with the outer frame 26 or other beams 27 by three or more beams 27 each extending in different directions. This configuration can suppress stress applied to the chip capacitors 35 due to a step difference between the seating faces 21 and 23 during the mounting process in the second step. Further, this configuration can ease stress applied to the lead frame 2 and the chip capacitors 35 due to a pressure from the mold resin 7 during encapsulation in this third step, too.

In the third step, stress applied to the lead frame 2 and the chip capacitors 35 due to a pressure from the mold resin 7 is eased by pressing the seating faces 21 and 22 of the lead frame 2 using the pins 9a and 9b, respectively, in the direction to the pedestal 10 during encapsulation with the molten mold resin 7. Further, even when stress is applied to the chip capacitors 35 due to a pressure from the mold resin 7 during encapsulation, it is the resin electrodes 353 of the chip capacitors 35 that peel off. Hence, breakage of the internal electrodes 352 and the element bases 351 can be prevented, which can in turn forestall a failure of the semiconductor device 1.

The shunt resistor 34 and the power terminal portions 4a and 4b are also mounted so as to bridge between two seating faces. However, these components are made of metal and a risk of stress-induced breakage of the main body is low. For this reason, the seating face 22 and the seating faces 24a and 24b do not have a structure in which each is integrated with the outer frame by three or more beams.

Subsequently, the outer frame 26 and the beams 27 of the lead frame 2 unwanted for the circuit are cut as a fourth step.

In the semiconductor device 1 manufacturing by the first step through the fourth step as above, the lead frame 2 has the surface exposed from the mold resin 7 on the side opposite to the surface on which the electronic components are mounted. Flatness of the lead frame 2 can be more readily achieved by allowing the lead frame 2 to have the surface on which no electronic components are mounted and which is not encapsulated with resin. The mounted electronic components include heating elements that generate heat. By taking this into consideration, the surface of the lead frame 2 on which no electronic components are mounted, that is, the surface exposed from the mold resin 7 may be bonded to a heat-releasing member, such as a heat sink. When configured in this manner, thermal stress applied to the lead frame 2 can be eased. Hence, breakage of the electronic components and the semiconductor device 1 can be prevented.

As has been described, according to the first embodiment, the semiconductor device 1 includes the lead frame 2 having a plurality of the electrically independent seating faces 21, 22, 23, 24a, and 24b, electronic components mounted on these seating faces via the conductive bonding material 6, and the mold resin 7 that encapsulates the lead frame 2 and the electronic components. Herein, because a resin electrode capacitor having resin electrodes is used as the chip capacitors 35 mounted so as to bridge between the two seating faces 21 and 23, it is the resin electrodes 353 that peel off when stress is applied to the chip capacitors 35. Hence, breakage of the internal electrodes 352 and the element bases 351 can be prevented, which can in turn forestall a failure of the semiconductor device 1. The semiconductor device 1 with excellent durability can be thus obtained.

According to the manufacturing method of a semiconductor device of the first embodiment, during encapsulation with the mold resin 7 after the chip capacitors 35 are mounted so as to bridge between the two seating faces 21 and 23 of the lead frame 2, the seating faces 21 and 22 are pressed by the pins 9a and 9b, respectively, in the direction to the pedestal 10. This configuration can prevent breakage of the chip capacitors 35 due to a pressure from the mold resin 7, which can in turn forestall a failure of the semiconductor device. Hence, a semiconductor device with excellent durability can be manufactured.

Also, the two seating faces 21 and 23 of the lead frame 2 on which the chip capacitors 35 are mounted so as to bridge therebetween are integrated with the outer frame 26 or other beams 27 using three or more beams 27 each extending in different directions. Hence, not only can the occurrence of a step difference between the two seating faces 21 and 23 be suppressed, but also stress applied to the lead frame 2 and the chip capacitors 35 due to a pressure from the mold resin 7 during encapsulation can be eased.

While the first embodiment has been described using resin electrode capacitors as an example of the electronic components mounted so as to bridge between the two seating faces 21 and 23 of the lead frame 2, it should be appreciated, however, that the invention is not limited to this example. Besides the resin electrode capacitors, electronic components having resin electrodes can be resin electrode resistors and coils, and all are available in the invention.

Also, the first embodiment has described the semiconductor device 1 forming the drive circuit responsible for motor control by ways of example. It should be noted, however, that the invention is applicable to general semiconductor devices having electronic components mounted so as to bridge between independent two seating faces of the lead frame and encapsulated with mold resin. It also should be appreciated that the embodiment of the invention can be modified or omitted as needed within the scope of the invention.

### Industrial Applicability

The invention can be used for a semiconductor device formed by mounting electronic components so as to bridge between independent seating faces of a lead frame followed by encapsulation with mold resin.

## Claims

1. A semiconductor device including a lead frame having a plurality of electrically independent seating faces, electronic components mounted on the seating faces via a conductive bonding material, and mold resin encapsulating the lead frame and the electronic components, the semiconductor device being **characterized in that**:
the electronic components include a first electronic component mounted so as to bridge between two seating faces out of the seating faces; and
the first electronic component has resin electrodes.

2. The semiconductor device according to claim 1, **characterized in that**:
the electronic components include a switching element;
the first electronic component is a capacitor; and
one resin electrode of the capacitor is bonded to the seating face on which the switching element is mounted.

3. The semiconductor device according to claim 1 or 2, **characterized in that**:
the lead frame has a surface exposed from the mold resin on a side opposite to a surface on which the electronic components are mounted.

4. The semiconductor device according to claim 3, **characterized in that**:
a heat-releasing member is bonded to the surface of the lead frame on the side opposite to the surface on which the electronic components are mounted.

5. A manufacturing method of a semiconductor device, **characterized by** comprising:
a first step of preparing a lead frame having an outer frame, a plurality of electrically independent seating faces disposed on an inner side of the outer frame, and connection portions each extending from the seating faces in a plurality of different directions and integrated with the outer frame;
a second step of mounting a first electronic component so as to bridge between two seating faces out of the seating faces of the lead frame, the second step being carried out subsequently to the first step;
a third step of placing the lead frame on a pedestal, encapsulating the lead frame and the first electronic component with molten mold resin while the two seating faces on which is mounted the first electronic component are pressed by corresponding pressing members, respectively in a direction to the pedestal, and removing the pressing members before the mold resin cures, the third step being carried out subsequently to the second step; and
a fourth step of cutting the outer frame and the connection portions unwanted for a circuit, the fourth step being carried out subsequently to the third step.

6. The manufacturing method of a semiconductor device according to claim 5, **characterized in that**:
the first electronic component mounted in the second step has resin electrodes.

7. The manufacturing method of a semiconductor device according to claim 5 or 6, **characterized in that**:
with three or more of the connection portions each extending in different directions, each of the two seating faces on which the first electronic component is mounted in the second step is integrated with the outer frame or other connection portions.
